# EUROPEAN PATENT SPECIFICATION

(11) **EP 0 329 418 B1**
(45) Date of publication and mention of the grant of the patent: **21.06.1995**
(21) Application number: 89301447.2
(22) Date of filing: 15.02.1989
(51) Int. Cl.: H03L 7/00, G06F 1/04

(54) **Circuit synchronization system**
Schaltungssynchronisationssystem
Système de synchronisation de circuits

(30) Priority: 17.02.1988 US 156779
(43) Date of publication of application: 23.08.1989
(73) Proprietor: SILICON GRAPHICS, INC., Mountain View, CA 94039-7311 (US)
(72) Inventor: Johnson, Mark G., Sunnyvale California 94086 (US); Hudson, Edwin L., Santa Clara California 95051 (US)
(74) Representative: Freeman, Jacqueline Carol

(56) References cited:
- GB-A- 2 127 594
- IEEE INTERNATIONAL SOLID STATE CIRCUITS CONFERENCE. vol. 31, 1988, 17-19 Febr.,New York,US;pages 142 - 143; MARK G.JOHNSON: "A variable delay line phase locked loop for CPU-CoProcessor Synchronization "

## Description

This invention relates to systems for synchronizing the operation of electronic circuits.

The synchronization of several circuits operating in a system is a problem faced by many system designers. For example, in high performance microprocessor-based systems, it is desirable to synchronize the operation of the various individual integrated circuits within the system to minimize dead time on the system bus, as well as prevent undesired data collisions. In automatic test systems, to assure validity for the input and output signals from the device being tested, all of the input pins of the device must be driven essentially simultaneously, while the condition of the output pins is monitored.

One solution to synchronizing microprocessor-based systems, not necessarily in the prior art, is described in "A 32-Bit VLSI CPU with 15-MIPS Peak Performance" by M. Forsyth, et al., IEEE Journal of Solid-State Circuits (Oct. 1987) SC-22(5):768-775. The system described in that paper employs a global master clock to which all integrated circuit operations are synchronized. Another solution is described in the British Patent GB-A- 2 127 594.

One well known technique for synchronizing the operation of the circuits is to employ a phase-locked loop circuit. The phase-locked loop circuit typically employs a phase detector to compare an input signal with a reference signal from a voltage-controlled oscillator. The output of the phase detector thus is proportional to the difference in phase between the input signal and the signal from the voltage-controlled oscillator. The output of the phase detector, representing the error between the signals, then is supplied through a low pass filter to control the voltage-controlled oscillator to lock to the incoming signal, despite an initial tuning which might not correspond to the input signal.

The present invention provides a system for synchronizing a first and second circuit operating from a common clock signal and each producing output signals, the system comprising first delay line means connected to receive the common clock signal and delay it by a selected interval before supplying it to the first circuit second delay line means connected to receive the clock signal and delay it by an adjustable interval in response to a control signal before supplying it to the second circuit and phase detection means connected to both of the first and second circuits for detecting when each produces an output signal and in response supplying the control signal to the second delay line means, the control signal having a voltage related to the difference between the output signals, the phase detecting means comprising filtering means connected to receive the control signal and average it over time before supplying it to the second delay line means.

In the preferred embodiment the phase detector consists of an edge-triggered flip-flop circuit.

The invention thus provides a variable delay line phase-locked loop technique which is particularly advantageous for synchronizing the operation of a central processing unit with a coprocessor, or with other chips in a microprocessor-based system. The system of the invention minimizes dead time on the system bus, and allows correction for variability in microprocessor operating speed resulting from variations in the manufacture of the microprocessors.

The invention is further described below, by way of example, with reference to the accompanying drawings, in which:
Figure 1 is a block diagram showing a system embodying the invention;
Figure 2 is a block diagram of the phase detector of Figure 1,
Figure 3 is a block diagram of the low pass filter of Figure 1,
Figure 4 is a block diagram of the voltage-controlled delay line of Figure 1, and
Figure 5 is a graph illustrating the operation of the delay line of Figure 4.

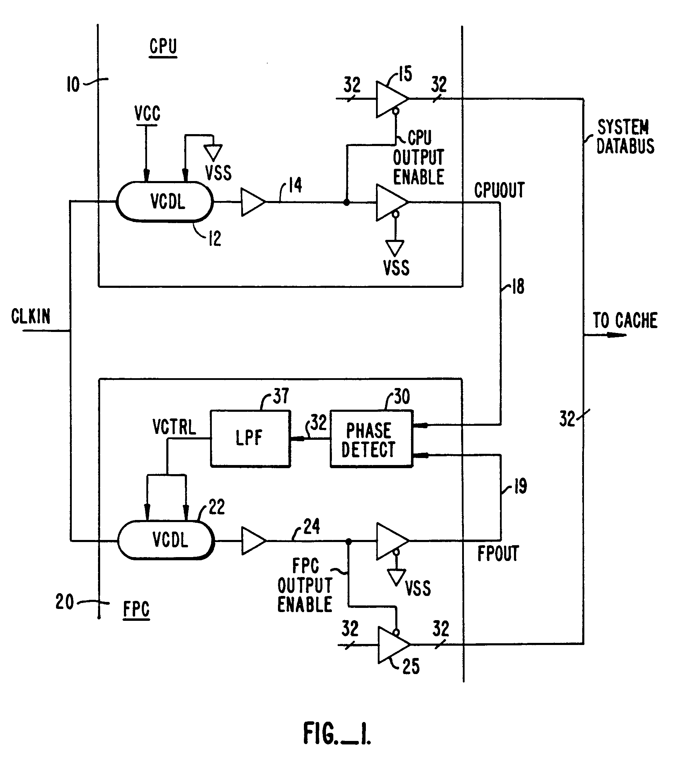

Figure 1 is a block diagram of a preferred embodiment of the invention as applied to synchronize the operation of a central processing unit 10 with a floating point coprocessor 20. Each of the CPU 10 and FPC 20 is connected to receive a clock signal CLKIN from an external clock source. In the CPU chip 10, the clock signal is supplied to a voltage-controlled delay line 12 where it is delayed by a fixed time interval having a duration which is described below. After being delayed, the clock signal is supplied on line 14 to the remainder of the chip, including where it is employed as a CPU output enable signal in conjunction with driver 15. In the preferred embodiment for a 32-bit wide bus, the output enable signal controls 31 other drivers in the manner of driver 15. The output enable signal permits the CPU to access the system data bus, and through that bus the cache memory (not shown).

To maximize the speed of operation of the entire system, it is important that the CPU chip 10 and the FPC chip 20 communicate with the cache at maximum speed, and therefore with minimal dead time on the system data bus. In a preferred embodiment the CPU chip 10 operates at greater than 10 million instructions per second, and therefore demands a very high bandwidth interface. In a preferred embodiment this bandwidth is achieved using a 16.7 megaHertz clock for the CPU and FPC by driving the cache interface pins twice per 60 nanosecond cycle, once for instructions and once for data. This pin multiplexing requires careful control of cache timing or else successive skew between the chips will narrow the data valid window, thereby violating setup and hold times and causing bus contention. The problem is made more severe because of differences in propagation delays in different chips as a result of variations in the manufacturing process. Variations in CMOS line width affect the switching speed of the chips, rendering the synchronization of the chips even more difficult.

The floating point coprocessor chip 20 also is connected to receive the clock signal CLKIN. The clock signal is immediately supplied to a voltage-controlled delay line 22, which unlike the delay line on the CPU, has a variable time delay. The output from the delay line is employed to enable the driver 25 to allow the FPC chip 20 access to the system data bus. In the same manner as with respect to the CPU for a 32-bit bus, there will be 32 drivers 25. The floating point chip also includes a phase detector 30 connected to receive the CPU output enable signal on line 18 and the FPC output enable signal on line 19. The phase detector supplies an output signal on line 32 indicative of the phase difference of the signals received on lines 18 and 19. When the CPU and FPC are properly synchronized, the signal on line 32 will indicate that the CPU output signal arrived first 50% of the time and that the FPC output signal arrived first 50% of the time. The output signal on line 32 is supplied to a low pass filter 37 which averages the output signal over time and supplies a control signal VCTRL to the variable voltage controlled delay line 22. Delay line 22 will lengthen or shorten the time delay of the clock signal passing through the delay line, thereby matching the FPC signal propagation delay to the CPU propagation delay, and synchronizing their operation.

In the foregoing description the phase detector, low pass filter, and variable voltage-controlled delay line have all been described as residing on the coprocessor chip. It should be appreciated, however, that these components could as easily be disposed on the CPU chip, with the fixed delay line being placed on the coprocessor chip, to achieve the same result. Either way the output enable lines enable the drivers 15 and 25 to place data on the bus or latch data from the bus.

In a conventional phase-locked loop system, the output of the phase detector is passed through a low pass filter to control a voltage-controlled oscillator. The voltage-controlled oscillator has a frequency output which is a function of voltage. Conventional phase-locked loop systems, however, are extremely sensitive to noise, and because such control systems have a pole, they are difficult to stabilize. In the system of our invention, the low pass filter is placed on chip to avoid noise between the internal ground and the external ground and prevent capacitive cross-talk between pins. The system is further advantageous as it allows the chips to be operated with slower or even interrupted clock signals to assist with debugging. When the chips are restarted, they will synchronize. With a conventional phase-locked loop system employing a voltage controlled oscillator which controls frequency, the clock signal cannot be slowed down or stopped entirely because if such occurs the oscillator is required to provide an instantaneous alteration in frequency with no error or settling time.

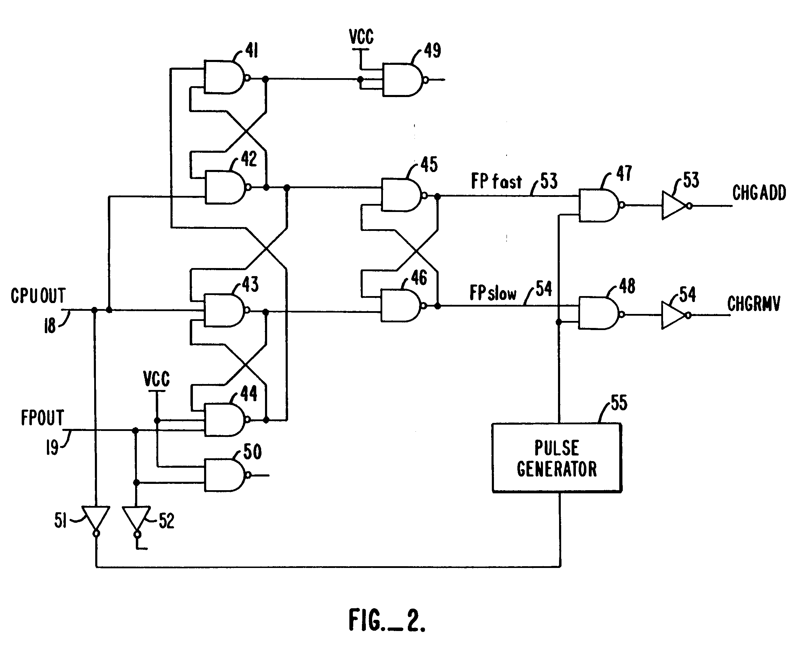

Figure 2 is a more detailed schematic of the phase detector 30 shown in block form in Figure 1. Phase detector 30 comprises an edge-triggered D-type flip-flop which, on the rising edge of signal CPUOUT samples signal FPOUT and places the result on output lines 53 and 54. If FPOUT goes high after CPUOUT goes high, then line 54, FPslow, will be low and line Fpfast will be high. On the other hand, the opposite will be the case if the floating point chip 20 has already gone high at the time its output is sampled by the signal CPUOUT. The CPUOUT signal on line 18 also drives a pulse generator 55 which enables NAND gates 47 and 48 for a fixed time, preferably on the order of 10 nano-seconds. This translates the CPUOUT and FPOUT input signals into charge add and charge remove output signals which are supplied to the low pass filter. Gates 49, 50 and 52 balance the loads being driven by the cross-coupled pairs of gates, thereby maintaining symmetrical operation at the same speed.

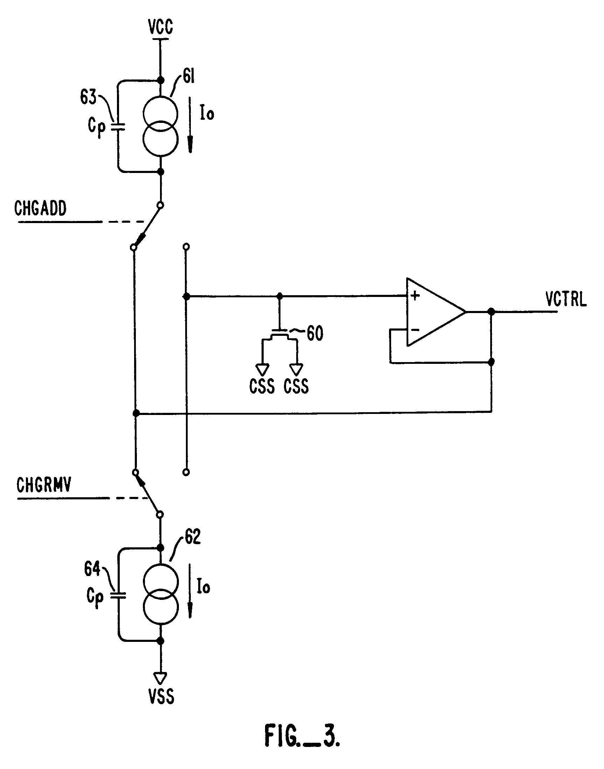

Figure 3 is a schematic of the low pass filter. The charge add and charge remove signals from the circuitry shown in Figure 2 are used to control a pair of switches which ultimately cause a large capacitor 60 to be charged or discharged by a pair of matched current sources 61 and 62. By virtue of the fixed width pulse from pulse generator 55, a fixed-size charge packet is pumped into or out of the capacitor on each cycle, thereby making the size of the correction step independent of the clock frequency. When the charge add and charge remove signals are not active, the switches are connected as shown in Figure 3 to short the parasitic capacitors 63 and 64 to the control voltage, thereby nulling charge-sharing errors.

The output signal from the circuit of Figure 3, VCTRL is used to drive the voltage-controlled delay line. Thus, if the floating point chip is too fast, Fpfast on line 53 is active, and therefore the charge add signal will also be active. During the time the pulse generator pulse is active, the charge add switch will be connected to capacitor 60 allowing charge to flow onto the capacitor 60. In a similar manner, if the FPC is slow, the charge remove line will be active, causing current source 64 to remove charge from the capacitor. During the time when neither the charge add nor the charge remove lines are active, the capacitor 60 floats. When the current source is not charging or discharging the filter capacitor, its output is shorted to node VCTRL, a low impedance version of the filter capacitor voltage. Any parasitic capacitance Cp is maintained at the filter capacitor voltage, so very little charge sharing occurs when the current source is connected to the filter capacitor. Thus, the combination of the phase detector and low pass filter provides a circuit which expresses a desired time delay as a function of voltage.

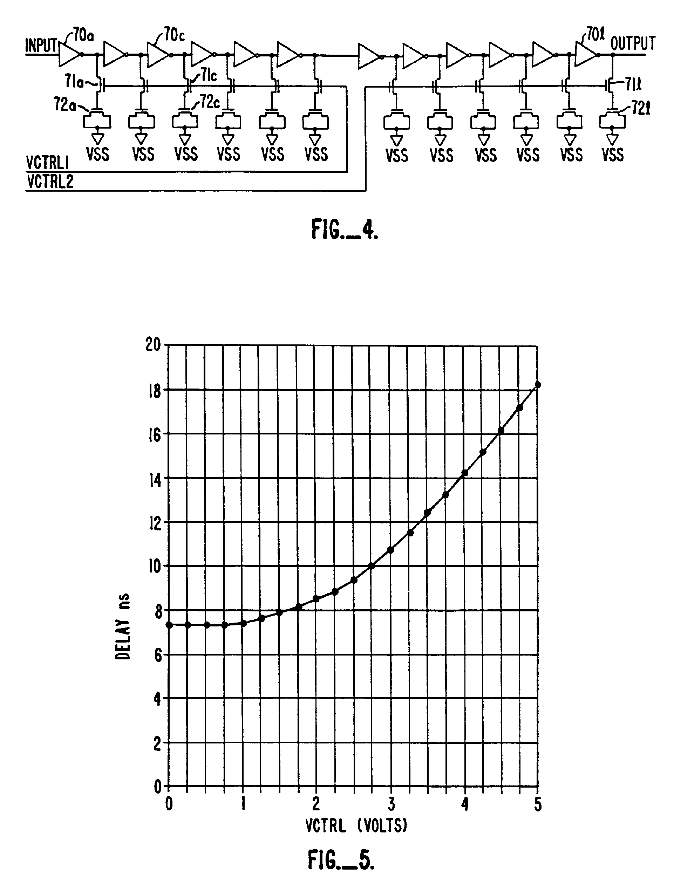

Figure 4 is a schematic of the voltage-controlled delay line shown in block form in Figure 1 as each of blocks 12 and 22. As shown in Figure 4, the delay line consists of a series of 12 drivers 70a, 70b . . . 701, 12 control transistors 71a, 71b . . . 711, and 12 capacitors 72a, 72b . . . 721. Each capacitor is connected to Vss. The theory of operation of the delay line is that each inverter 70c has an output impedance which will drive its load capacitor 72c. By varying the RC time constant, a longer delay is provided. In other words, by changing the resistive load on the output of each driver, more of the capacitive load may be made "visible" to the inverter. By employing the transistors 71, for a small gate-to-source voltage an open circuit is provided, and the transistor is essentially off. By the time the transistor gate reaches about 2 volts, it is turned on, coupling the capacitance directly to the output terminal.

The circuit shown in Figure 4 is employed as the voltage-controlled delay line 12 in the CPU chip 10, as well as the delay line 22 in the floating point coprocessor chip 20. In the case of the CPU chip, the delay line is set at one-half its tuning range by connecting one of control lines VCTRL1 or VCTRL2 to Vcc and the other to Vss. Thus, half the inverters are effectively completely disconnected from the load capacitors, while the other six inverters are effectively connected directly to the capacitor. In contrast, in the floating point coprocessor 20 the control lines VCTRL1 and VCTRL2 are shorted together and connected to receive the VCTRL signal from the output terminal of Figure 3. The voltage control delay line employs stages in pairs so that differences between rising and falling propagation delays are cancelled, thereby keeping the clock signal essentially symmetrical. Under minimum allowed supplied voltage and maximum temperature, the adjustment range is approximately 12 nanoseconds and the delay coefficient is about 3 nanoseconds per volt, as shown in Figure 5. As shown there, the operation of the circuit is essentially linear for control voltages greater than 2 volts.

Once the circuitry shown in Figures 1-4 acquires phase lock, the fixed size correction step will exceed the phase error and the circuit will apply alternating corrections to maintain equilibrium. Therefore, to minimize phase jitter, the correction step size is chosen to be small. While this results in relatively long capture time, because the phase capture takes place only during a system reset, this slow capture is not disadvantageous. Furthermore, once phase lock is acquired, changes in the CPU or FPC propagation delays as a result of temperature or supply voltage changes are easily tracked and corrected.

Because the phase-locked loop system of our invention controls the time delay instead of frequency, an external system may be employed to alter the clock period during operation of the circuitry being synchronized. Conventional phase-locked loop systems employing voltage-controlled oscillators cannot track such events, and are subject to significant noise effects. In the case of our circuit, a hypothetical hundred millivolts of noise on VCTRL produces only 0.3 nanoseconds of output jitter. In contrast, the voltage-controlled oscillator will have a coefficient on the order of 12 megaHertz per volt, thereby producing much more output jitter for the same hypothetical noise.

In the preceding description of the preferred embodiment, various circuit implementation details have been provided to enable a complete understanding of the preferred embodiment of the invention. The scope of the invention is set forth in the appended claims.

## Claims

1. A system for synchronizing a first and second circuit operating from a common clock signal and each producing output signals, the system comprising:
first delay line means (12) connected to receive the common clock signal and delay it by a selected interval before supplying it to the first circuit;
second delay line means (22) connected to receive the clock signal and delay it by an adjustable interval in response to a control signal before supplying it to the second circuit; and
phase detection means (30) connected to both of the first and second circuits for detecting when each produces an output signal and in response supplying the control signal to the second delay line means, the control signal having a voltage related to the difference between the output signals, the phase detecting means comprising filtering means (37) connected to receive the control signal and average it over time before supplying it to the second delay line means (22).

2. A system as claimed in claim 1 wherein the phase detection means (30) comprises means for detecting which of the output signals from the two circuits was earlier.

3. A system as claimed in claim 2 wherein the means for detecting comprises an edge-triggered flip-flop circuit.

4. A system as claimed in claim 1, 2 or 3 wherein the filtering means (37) comprises:
a first current source switchably connected by a first switch between a storage capacitor and an upper potential source;
a second current source switchably connected by a second switch between the storage capacitor and a lower potential source; and
switching means responsive to the control signal for controlling the first and second current sources.

5. A system as claimed in claim 4 wherein the switching means comprises:
a pulse generator for supplying pulses;
a first gate connected to receive the pulses and a complementary control signal and having a second output coupled to the second switch.

6. A system as claimed in any preceding claim wherein the first delay line means (12) comprises a first voltage-controlled delay line having a plurality of stages providing a range of time delays;
wherein the second delay line means (22) comprises a second voltage-controlled delay line having a plurality of stages providing a range of time delays; and
wherein the time delay of the first delay line is set to be midway in the range of delays.

7. A system as claimed in any one of claims 1-5 wherein the second delay line means (22) comprises a voltage-controlled delay line for delaying the clock signal by a time related to the voltage of the control signal.

8. A system as claimed in claim 7 wherein the voltage-controlled delay line includes at least one stage comprising:
an inverter having an input terminal connected to receive the clock signal and an output terminal;
a resistor-capacitor network having a variable time constant, the network connected between the output terminal and a fixed potential; and
control means connected to receive the control signal and in response vary the time constant.

9. A system as claimed in claim 8 wherein the network comprises:
a capacitor having a first electrode connected to the fixed potential; and
a transistor having a first electrode connected to the inverter, a second electrode to a second electrode of the capacitor, and a control electrode connected to receive the control signal.

10. A system as claimed in claim 8 or 9 wherein the voltage-controlled delay line comprises a plurality of stages.

11. A system as claimed in claim 10 wherein the delay line comprises an even number of stages.

## Patentansprüche

1. System zum Synchronisieren einer von einem gemeinsamen Taktsignal betriebenen und jeweils Ausgangssignale erzeugenden ersten und zweiten Schaltung, wobei das System erstes Verzögerungsleitungsmittel (12), angeschlossen, um das Taktsignal zu empfangen und um es vor dem Anlegen an die erste Schaltung um ein ausgewähltes Intervall zu verzögern, zweites Verzögerungsleitungsmittel (22), angeschlossen, um das Taktsignal zu empfangen und um es vor dem Anlegen an die zweite Schaltung auf ein Steuersignal ansprechend um ein verstellbares Intervall zu verzögern, und an sowohl die erste als auch die zweite Schaltung angeschlossenes Phasendiskriminationsmittel (30) zum Feststellen, wann jede ein Ausgangssignal produziert, und um daraufhin das Steuersignal an das zweite Verzögerungsleitungsmittel zu legen, wobei das Steuersignal eine mit der Differenz zwischen den Ausgangssignalen verwandte Spannung hat, umfaßt, wobei das Phasendiskriminationsmittel Siebmittel (37) umfaßt, die angeschlossen sind, um das Steuersignal vor dem Anlegen an das zweite Verzögerungsleitungsmittel (22) zu empfangen und seinen zeitbezogenen Mittelwert zu bilden.

2. System nach Anspruch 1, wobei das Phasendiskriminationsmittel (30) Mittel zum Feststellen, welches der Ausgangssignale von den zwei Schaltungen früher war, umfaßt.

3. System nach Anspruch 2, wobei das Mittel zum Feststellen eine flankengesteuerte Kippschaltung umfaßt.

4. System nach Anspruch 1, 2 oder 3, wobei das Siebmittel (7) eine durch einen ersten Schalter zwischen einem Speicherkondensator und einer oberen Potentialquelle schaltbar angeschlossene erste Stromquelle, eine durch einen zweiten Schalter zwischen dem Speicherkondensator und einer unteren Potentialquelle schaltbar angeschlossene zweite Stromquelle und ein auf das Steuersignal ansprechempfindliches Schaltmittel zum Regeln der ersten und zweiten Stromquelle umfaßt.

5. System nach Anspruch 4, wobei das Schaltmittel einen Impulsgenerator zum Liefern von Impulsen, ein zum Empfangen der Impulse angeschlossenes erstes Tor und ein komplementäres Steuersignal umfaßt und einen zweiten, an den zweiten Schalter gekoppelten Ausgang hat.

6. System nach einem der vorangehenden Ansprüche, wobei das erste Verzögerungsleitungsmittel (12) eine erste spannungsgesteuerte Verzögerungsleitung mit einer eine Reihe von Zeitverzögerungen liefernden Vielzahl von Stufen umfaßt, wobei das zweite Verzögerungsleitungsmittel (22) eine zweite spannungsgesteuerte Verzögerungsleitung mit einer eine Reihe von Zeitverzögerungen liefernden Vielzahl von Stufen umfaßt und wobei die Zeitverzögerung der ersten Verzögerungsleitung auf die Mitte der Reihe von Verzögerungen eingestellt ist.

7. System nach einem der Ansprüche 1 - 5, wobei das zweite Verzögerungsleitungsmittel (22) eine spannungsgesteuerte Verzögerungsleitung zum Verzögern des Taktsignals um eine mit der Spannung des Steuersignals verwandte Zeit umfaßt.

8. System nach Anspruch 7, wobei die spannungsgesteuerte Verzögerungsleitung zumindest eine Stufe enthält, umfassend einen Wechselrichter mit einer zum Empfangen des Taktsignals angeschlossenen Eingangsklemme und einer Ausgangsklemme, einen Widerstand-Kondensator-Zweipol mit einer variablen Zeitkonstante, wobei der Zweipol zwischen der Ausgangsklemme und einem festen Potential angeschlossen ist, und Steuermittel, angeschlossen, um das Steuersignal zu empfangen und die Zeitkonstante dementsprechend zu variieren.

9. System nach Anspruch 8, wobei der Zweipol einen Kondensator, bei dem eine erste Elektrode an dem festen Potential angeschlossen ist, und einen Transistor, bei dem eine erste Elektrode am Wechselrichter, eine zweite Elektrode an einer zweiten Elektrode des Kondensators und eine zum Empfangen des Steuersignals angeschlossene Steuerelektrode angeschlossen ist, umfaßt.

10. System nach Anspruch 8 oder 9, wobei die spannungsgesteuerte Verzögerungsleitung eine Vielzahl von Stufen umfaßt.

11. System nach Anspruch 10, wobei die Verzögerungsleitung eine gerade Zahl von Stufen umfaßt.

## Revendications

1. Système de synchronisation d'un premier et d'un second circuit fonctionnant à partir d'un signal d'horloge commun et produisant chacun des signaux de sortie, le système comprenant:
un premier moyen de ligne à retard (12) connecté pour recevoir le signal d'horloge commun et le retarder par un intervalle sélectionné avant de le fournir au premier circuit;
un second moyen de ligne à retard (22) connecté pour recevoir le signal d'horloge et le retarder par un intervalle réglable en réponse à un signal de commande avant de le fournir au second circuit; et
un moyen de détection de phase (30) connecté aux deux premier et second circuits pour détecter le moment où chacun produit un signal de sortie et en réponse fournir le signal de commande au second moyen de ligne à retard, le signal de commande ayant une tension liée à la différence entre les signaux de sortie, le moyen de détection de phase comprenant un moyen de filtrage (37) connecté pour recevoir le signal de commande et l'égaliser dans le temps avant de le fournir au second moyen de ligne à retard (22).

2. Système selon la revendication 1, dans lequel le moyen de détection de phase (30) comprend un moyen pour détecter celui des signaux de sortie des deux circuits qui était le premier.

3. Système selon la revendication 2, dans lequel le moyen de détection comprend un circuit de bascule déclenchée par front.

4. Système selon la revendication 1, 2 ou 3, dans lequel le moyen de filtrage (37) comprend:
une première source de courant connectée de façon commutable par un premier commutateur entre un condensateur accumulateur d'énergie et une source de potentiel supérieur;
une seconde source de courant connectée de façon commutable par un second commutateur entre le condensateur accumulateur d'énergie et une source de potentiel inférieur; et
un moyen de commutation sensible au signal de commande pour commander les première et seconde sources de courant.

5. Système selon la revendication 4, dans lequel le moyen de commutation comprend:
un générateur d'impulsions pour fournir des impulsions;
une première porte connectée pour recevoir les impulsions et un signal de commande complémentaire et ayant une seconde sortie couplée au second commutateur.

6. Système selon l'une quelconque des revendications précédentes, dans lequel le premier moyen de ligne à retard (12) comprend une première ligne à retard commandée en tension ayant une pluralité d'étages fournissant une gamme de temporisations;
dans lequel le second moyen de ligne à retard (22) comprend une seconde ligne à retard commandée en tension ayant une pluralité d'étages fournissant une gamme de temporisations; et
dans lequel la temporisation de la première ligne à retard est réglée pour se situer à mi-chemin dans la gamme de retards.

7. Système selon l'une quelconque des revendications 1 à 5, dans lequel le second moyen de ligne à retard (22) comprend une seconde ligne à retard commandée en tension pour retarder le signal d'horloge par un temps lié à la tension du signal de commande.

8. Système selon la revendication 7, dans lequel la ligne à retard commandée en tension comporte au moins un étage comprenant:
un circuit inverseur ayant une borne d'entrée connectée pour recevoir le signal d'horloge et une borne de sortie;
un réseau à résistance et capacité ayant une constante de temps variable, le réseau (étant) connecté entre la borne de sortie et un potentiel fixe; et
un moyen de commande connecté pour recevoir le signal de commande et en réponse varier la constante de temps.

9. Système selon la revendication 8, dans lequel le circuit comprend:
un condensateur ayant une première électrode connectée au potentiel fixe; et
un transistor ayant une première électrode connectée au circuit inverseur, une seconde électrode à une seconde électrode du condensateur, et une électrode de commande connectée pour recevoir le signal de commande.

10. Système selon la revendication 8 ou 9, dans lequel la ligne à retard commandée en tension comprend une pluralité d'étages.

11. Système selon la revendication 10, dans lequel la ligne à retard comprend un nombre d'étages pair.
